(19) **Europäisches Patentamt**
**European Patent Office**
**Office européen des brevets**

(11) **EP 2 270 838 B1**

(12) **EUROPEAN PATENT SPECIFICATION**

(45) Date of publication and mention
of the grant of the patent:
**12.06.2019 Bulletin 2019/24**

(51) Int Cl.:
***H01L 21/67*** *(2006.01)*

(21) Application number: **10167177.4**

(22) Date of filing: **24.06.2010**

(54) **Method and apparatus for controlling optimal operation of acoustic cleaning**

Verfahren und Vorrichtung zum Steuern des optimalen Betriebs einer akustischen Reinigung

Procédé et appareil pour contrôler le fonctionnement optimal du nettoyage acoustique

(84) Designated Contracting States:
**AL AT BE BG CH CY CZ DE DK EE ES FI FR GB
GR HR HU IE IS IT LI LT LU LV MC MK MT NL NO
PL PT RO SE SI SK SM TR**

(30) Priority: **02.07.2009 US 222712 P**

(43) Date of publication of application:
**05.01.2011 Bulletin 2011/01**

(73) Proprietor: **IMEC VZW**
**3001 Leuven (BE)**

(72) Inventors:
• **Brems, Steven**
**B-3000 Leuven (BE)**
• **Mertens, Paul**
**B-2820 Bonheiden (BE)**

(74) Representative: **Pronovem**
**Office Van Malderen**
**Avenue Josse Goffin 158**
**1082 Bruxelles (BE)**

(56) References cited:
**WO-A1-2008/138725     US-A1- 2001 013 355**

**Description**

**Field of the Invention**

The present invention is related to methods and apparatuses for cleaning a substrate, in particular a semiconductor substrate, using megasonic energy.

**State of the art.**

Megasonic cleaning techniques are known in the art and are presently widely applied in the semiconductor industry. The performance of megasonic cleaning depends on several process parameters such as frequency, dissolved gas in the cleaning liquid, applied power, acoustic field geometry, refreshing of the cleaning liquid, wafer positions or chemical concentrations. Despite the wide application of megasonic cleaning, the importance of each individual process parameter is still not sufficiently clear.

Even the physical mechanisms, which are responsible for the removal of particles, e.g. Schlichting streaming, microstreaming and acoustic cavitation are still under debate. The reason is that basic physical processes and forces, which are involved in the cleaning process, are little understood. All these uncertainties make it very difficult to optimize megasonic cleaning tools to the ever more stringent requirements of the semiconductor industry. The process window of physical forces in which structures can be cleaned without creating damage narrows continuously. As a result, a precise control over the physical forces during megasonic cleaning is extremely important.

In document WO-A-2004071938, a method and apparatus are disclosed wherein a megasonic transducer is oriented towards a substrate and wherein a dynamically adjustable RF generator is provided, that has an output coupled to the transducer. The RF generator is adjusted to maintain a resonance state of the transducer, thereby obtaining improved cleaning efficiency. Even though this provides an improvement over systems wherein no such control is applied, a further optimization is desirable. In document WO2008-A-138725 a method and apparatus is described for ultrasonic wet treatment of a wafer, which comprises bringing a solid element, which is connected to a transducer in close proximity to a surface of a wafer so that a gap having a distance d2 is formed between the solid element and the wafer, dispensing liquid for filling the gap between the solid element and the wafer, and detecting ultrasonic waves and/or controlling the distance d2, by measuring the distance d2, comparing the measured distance with a desired distance dO and adjusting the distance accordingly.

**Aims of the invention**

The present invention aims to provide an improvement over systems as described above.

**Summary of the invention**

The invention is related to methods and apparatuses as disclosed in the appended claims. In particular, the invention is related to method for cleaning a surface of a substrate, in particular a semiconductor substrate such as a silicon wafer, by the steps of:

- Positioning the substrate so that the surface is at a distance from a piezo-electric transducer,
- Supplying a cleaning liquid between the substrate and the transducer,
- Applying an oscillating acoustic force to the cleaning liquid by actuating the transducer, i.e. by applying an alternating current and voltage to said transducer,
- Moving the transducer with respect to the substrate or vice versa,

characterized in that at several points in time during said movement the the following sequence of steps is performed :

- Measuring the phase shift between the current and voltage applied to said transducer,
- Comparing the measured phase shift to a desired value of the phase shift,
- Adjusting the distance between the surface and the transducer so that said phase shift is maintained equal to said desired value of the phase shift.

According to the preferred embodiment, said desired value of the phase shift is zero. The frequency of said alternating current and voltage is preferably substantially constant.

According to an embodiment, said transducer is mounted in a nozzle for producing a liquid column between said nozzle and said surface.

According to another embodiment, said transducer is mounted against a side wall of a reservoir configured to be filled with the cleaning liquid and to receive one or more substrates submerged in said liquid.
The invention is equally related to an apparatus for cleaning a surface of a substrate, comprising:

- a piezo-electric transducer,

- means for positioning a substrate at a controllable distance from said transducer,

- means for providing a cleaning liquid between the transducer and the substrate,

- means for connecting the transducer to a power source, to thereby apply an alternating current and voltage to said transducer,

- means for measuring the phase shift between said current and voltage,

- a feedback control system for adjusting said controllable distance so that said phase shift remains equal to a desired value.

Said means for providing a cleaning liquid may comprise a nozzle, or said means for providing a cleaning liquid may comprise a reservoir in which a substrate may be submerged, and wherein the transducer is attached to a side wall of said reservoir. According to an embodiment, the feedback control system comprises an electromagnetically driven vertical positioning gear.

**Brief description of the figures**

Figure 1 represents schematically the experimental set-ups of the disclosure: (a) nozzle system: (b) small cell system.
Figure 2a-2b shows the impedance and phase measurements of the transducer as a function of the frequency. Figure 2a shows graphs when a wafer is inserted at 4 different distances from the transducer, while figure 2b shows the same measurements when the wafer is replaced by a piece of damping material.
Figure 3 shows an example of an apparatus according to the invention.
Figure 4a-4b shows the frequencies that correspond to a zero phase shift between the voltage and current signals as a function of the sample position (i.e. the distance between the sample and the wafer), for a damping material (figure 4a) and for a wafer piece (figure 4b) .
Figure 5 shows the real power delivered to the transducer as a function of the position of the wafer (solid squares) and damping material (gray circles). A large oscillation of the real power is present when acoustic waves are reflected from the wafer.
Figure 6 (a) shows the cross section of the nozzle set-up. Imperfections of the vacuum chuck cause a small flexion of the wafer. Figure 6 (b) represents a typical non-uniform particle removal efficiency (PRE) pattern obtained with the nozzle set-up.
Figure 7 (a) shows the fluctuation of the real power delivered to the transducer and the PRE as a function of the distance between the transducer and the wafer. Figure 7 (b) shows the correlation between the PRE and the real power.

**Detailed description of the invention**

A method and apparatus is disclosed to control the performance of acoustic cleaning. For megasonic cleaning tools with a face-to-face configuration of an acoustic transducer and substrate (wafer), the method comprises selecting and controlling a distance between the transducer and the substrate (wafer) according to the teaching of the present disclosure, thereby leading to improved cleaning performance. A measure of the cleaning performance is the Particle Removal Efficiency (PRE).
The acoustic field geometry can have a large impact on the performance of megasonic transducers. A reflection of acoustic waves back into a transducer imposes mechanical constraints on the piezoelectric material. This effect can be described with electrical and stress-strain relationships, which are applicable to piezo-electric materials:

$$D_i = \varepsilon_{ij} E_j + e_{ijk} T_{jk} \qquad\qquad [1]$$

$$\sigma_{ij} = e_{ijk}\, E_k + s_{ijkl}\, T_{kl} \qquad\qquad [2]$$

In eq. (1) and (2) D is the electrical displacement, $\sigma_{ij}$ is the strain field, E is the electrical field, T is the stress field, e is defined as the piezo-electrical strain constants and $\varepsilon$ and s describe the dielectric and elastic properties under conditions of constant stress and constant electric field, respectively.

A confinement of piezoelectric material when an electric field is applied, results in stress (eq. 2). This stress contributes to the electrical displacement and changes the relation between E and D. As a result, acoustic reflections back into a transducer change the electrical behaviour of a transducer.

The invention is related to a method for cleaning a substrate, in particular a semiconductor substrate such as a silicon wafer, by the steps of:

- Positioning the substrate at a distance from a piezo-electric transducer,
- Supplying a cleaning liquid between the substrate and the transducer,
- Applying an oscillating acoustic force to the cleaning liquid by actuating the transducer, i.e. by applying an alternating current and voltage to said transducer,
- Moving the transducer with respect to the substrate or vice versa,

wherein at several points in time during said movement the the following sequence of steps is performed :

- Measuring the distance between the surface and the transducer,
- Comparing the measured distance to a desired distance,
- Adjusting the distance between the surface and the transducer so that said distance is maintained substantially equal to said desired distance.

In stead of directly measuring the distance, it is also possible to measure the phase shift between the alternating current and voltage applied to the transducer, and to maintain said phase shift constant or preferably zero during the movement. This will have the same effect of keeping the distance between the transducer and the substrate constant.

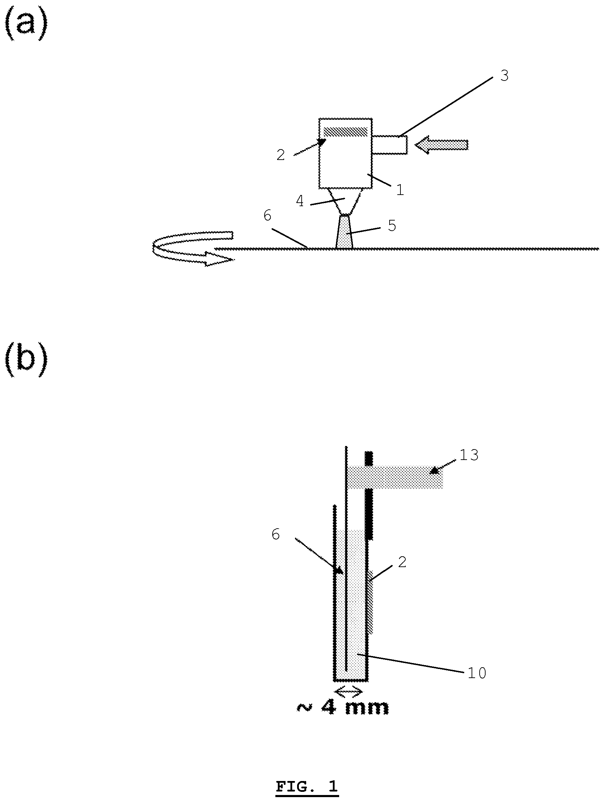

Two possible set-ups in which the method may be applied are illustrated in figure 1a and 1b. In the setup of figure 1a, a nozzle 1 is provided, which comprises the transducer 2. A supply 3 of cleaning liquid can be supplied to the nozzle, so that liquid streams out of the nozzle outlet 4, creating a liquid column 5 between the nozzle and the surface 6 to be cleaned. Actuation of the transducer generates acoustic waves which propagate in the liquid column 5. Actuation of the transducer takes place through a power source, e.g. a combination of a function generator and an amplifier, to which the transducer is connected. The nozzle 1 may be scanned over the surface and/or the surface moved (e.g. rotated) with respect to the nozzle, in order to clean the surface. The setup of figure 1b shows a megasonic cell, which is a reservoir 10 which may be filled with a cleaning liquid, and in which the substrate 6 to be cleaned may be submerged. A transducer 2 which may be the same type of transducer as used in the setup of figure 1a is attached to the side wall of the reservoir. A micrometer screw 13 is provided for test purposes (see test results described further), for performing measurements with different distances between the substrate and the transducer.

The power source provides a high frequency voltage and current to the transducer. The impedance of the transducer can be measured by measuring this voltage and current, and said impedance is highest when the phase shift between voltage and current is minimum. As known in the art, this is the condition at which the highest cleaning efficiency is obtained. This condition corresponds to the resonance frequency of the transducer system.

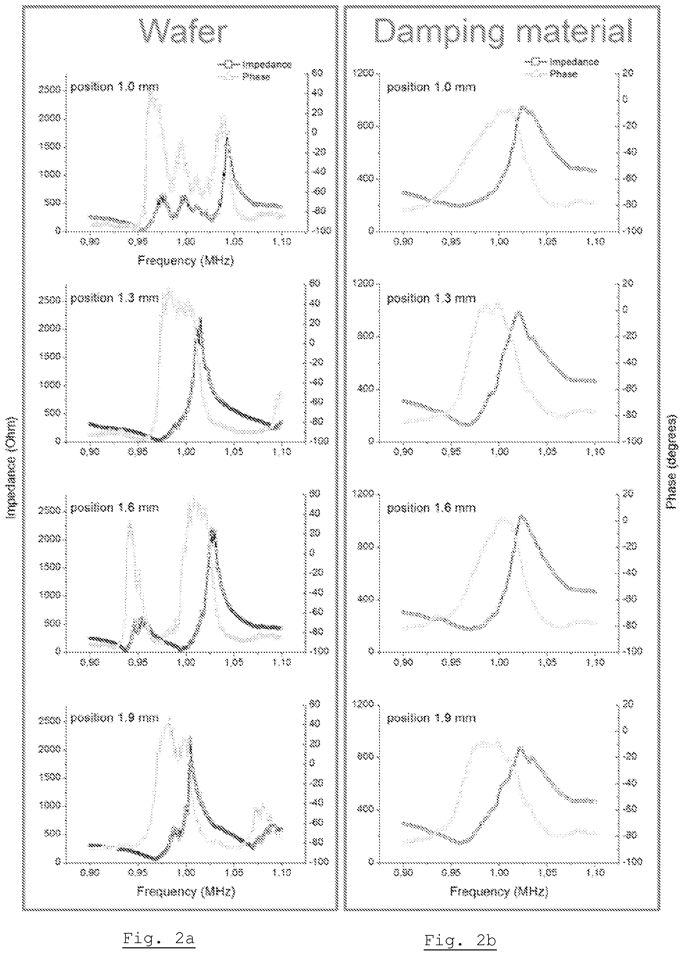

From impedance measurements obtained with the setup of figure 1b, the results of figure 2a were obtained. The four graphs shown in this figure correspond to four separate distances (1mm, 1.3mm, 1.6mm and 1.9mm) between the transducer and the substrate. A half-wavelength of a 1 MHz sound field in water corresponds to approximately 0.75 mm. The substrate was a standard Si-wafer. Attention is drawn primarily to the amplitude spectrum (black curves). What is apparent is not only that the resonance frequency (and the number of resonance frequencies) changes as a function of the distance between the transducer and the substrate, but also that the shape and height of the highest resonance peak changes. These latter features are directly related to the cleaning efficiency. By consequence, even if the frequency of the voltage and current supplied to transducer is varied to comply with a resonance condition (as in prior art systems), a variation of the distance between the transducer and the substrate (due to a topography of the surface to be cleaned or a curvature of said surface) may lead to considerable variations in cleaning efficiency. According to the method of the invention, the frequency is maintained substantially constant, while the distance between the transducer and the surface is controlled to remain as close as possible to a predefined set value, by measuring the distance directly or by measuring the phase shift between the current and voltage and applying the measured values in a feedback loop. In this way, only one of the graphs of figure 2a applies throughout the cleaning process, which ensures a constant optimal cleaning efficiency. The graphs in figure 2b are related to measurements wherein the wafer was replaced by a damping material, to illustrate the fact that reflections (in the case of figure 2a) have an important effect on the resonance frequency. The situation to which the method of the invention is mainly applicable is the situation where an actual wafer is cleaned (i.e. the graphs of figure 2a).

The desired distance is the distance at which the particle removal efficiency is at a maximum. This can also be expressed as: the desired distance is the distance at which the real power consumed by the transducer is at a maximum, the real power being equal to the dissipated acoustical power in the liquid. As explained in the paragraph on test results, a strong dependency has been established between PRE and real power on the one hand and on the other hand said distance between the transducer and the substrate surface to be cleaned.

In state of the art (conventional) setups for acoustic cleaning the distance between the reflecting surface and the transducer is not constant as scanning proceeds, due to mechanical tolerances, imperfect geometry, non-flatness of the substrate. This is the case for example in the system of WO2004071938.

The present disclosure describes a modified set-up/configuration (in the case of figure 1a), wherein a vertical positioning gear adjusts the distance between the transducer and the (reflecting) surface while scanning proceeds, such that the phase shift between voltage and current is kept constant, and preferably zero. This is equivalent to maintaining the distance between the substrate and the transducer equal to a desired distance (i.e. the desired distance is the distance at which, at the frequency of the power source, the phase shift between voltage and current is equal to a predefined value, preferably zero). This can be achieved by a feedback control system that compares the measured phase shift to the desired value and feeds correction into a vertical positioning gear, thereby adjusting the distance between the transducer and the reflecting surface. This gear could be electromagnetically driven.

In some applications maximum active (real) power is desired. In such case the feedback control system will minimize the absolute value of the phase shift angle between voltage and current and feeds the corresponding correction into a vertical positioning gear, thereby adjusting the distance between the transducer and the reflecting surface.

Alternatively, a control system can maximize the active (real) power by controlling the distance between the transducer and the reflecting surface. In different embodiments of the disclosure a single transducer is scanning the entire surface. Cleaning chemicals are delivered to the wafer through (spray) nozzle(s) above the wafer.

Alternatively in other embodiments, a set of multiple transducers can be used in parallel to treat at least a part of the surface or the entire surface at once.

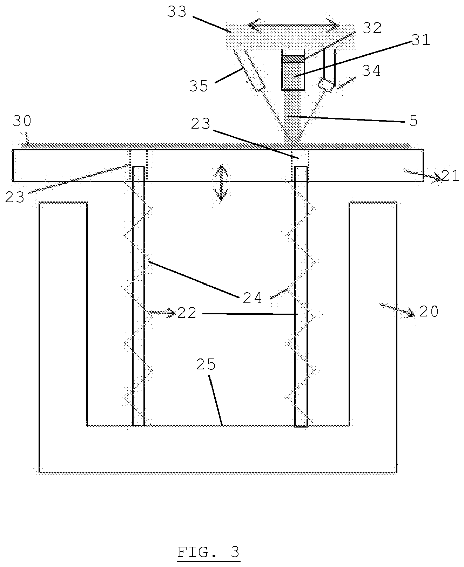

Figure 3 shows a possible apparatus according to the invention. The apparatus comprises an electromagnet 20, and a wafer support table 21, supported on support legs 22. The support table is vertically movable via linear bearings 23 with respect to the support legs 22, with springs 24 arranged between the base 25 and the support table 21. These parts define a magnetic levitation system: the magnet 20 is connectable to a power source, while actuation of the magnet will cause an attraction or repulsion between the magnet 20 and the support table 21, against the bias of the springs 24. In this way, a vertical movement of the support table 21 can be actuated. A wafer (substrate) 30 may be positioned on the support table. The nozzle 31, comprising the transducer 32 is mounted on a movable structure 33 which can move in the direction parallel to the wafer surface. The distance change between the wafer 30 and the transducer 32 is measured with a combination of an optical sensor 34, for example a position sensitive photo-detector, and a focused light beam that can be produced with a laser 35. This distance measurement system (comprising the sensor 34 and laser 35) is mounted on the same structure 19 as the nozzle and transducer and, as a result, it follows the movement of the transducer. A feedback loop is provided between the optical distance measurement and the magnetic levitation of the wafer so that each distance change is corrected by the magnetic levitation system comprising the electromagnet(s), springs and linear bearings. The details of the apparatus of figure 3 can be according to known technologies, described for example in the following documents:

- "The laser displacement measurement with feedback control in a magnetic levitation and suspension system", Lin et al, Comput. Methods Appl. Mech. Engrg. 190 (2000) 25-34.

- "Robust force control for a magnetically levitated manipulator using flux density measurement", Yi et al, Control Eng. Practice, Vol 4, No 7, pp. 957-965, 1996.

The apparatus of figure 3 is merely an example of an apparatus suitable for performing the method of the invention. For example, the magnetic levitation system may be configured to actuate the movement of the nozzle and transducer in stead of the wafer. In stead of an optical sensor and a laser, an acoustical sensor could be used for the distance measurement. As described before, the phase signal between voltage and current signals could also be used as an input for the feedback loop to keep the distance between wafer and transducer at the desired value for a substantially constant frequency.

**Examples - test results**

All described tests have been performed with a face-to-face configuration between the transducer and the wafer or damping material. Two different megasonic tools are used to demonstrate the effect of acoustic reflections on the performance of a transducer.

The first experimental system is a 200 mm single wafer megasonic tool represented schematically in Figure 1(a). A 1 MHz megasonic nozzle is moved at a constant speed over the rotating wafer and will be referred to as the nozzle system.

The active diameter of the cylindrical megasonic transducer is 11 mm. The liquid is flowing out of the exhaust port of the nozzle and the acoustic waves are propagating within the resulting liquid-column. The acoustic waves are converged to a point in the vicinity of the exhaust port, which is about 4 mm below the exhaust. The height of the nozzle can be adjusted with an accuracy of 10 $\mu$m with respect to the centre of the wafer. The cleaning liquid is deionized water (DIW) with a controlled amount of dissolved $O_2$ gas.

All results in this disclosure are obtained with a nozzle speed of 50 cm/min, a wafer rotation of 1000 rpm and a water flow of 1.5 1/min. The water was saturated with $O_2$ gas.

The second system is a small megasonic cell with the same type of transducer mounted to a glass cell as shown schematically in Figure 1(b). The liquid is DIW and the dissolved gases are not controlled. The inner dimensions of the cell are 4 x 20 x 40 mm$^3$ and a sample piece or thin damping material can be immersed in the cell. The transducers of both systems are driven by a combination of a function generator and an amplifier. The electrical signals delivered to the transducers are measured with a current and voltage probe, which are directly connected to an oscilloscope. Furthermore, the piezoelectric transducer of the cell (fig. 1b) is also characterized by impedance analyzer measurements. The electrical impedance measurements are made with an Agilent HP 4294 impedance analyzer.

The influence of acoustic reflections on the electrical properties of a transducer was investigated. Electrical measurements can estimate the resonance frequency of the transducer and the acoustical power delivered to the liquid.

The impedance analyzer measurements can be influenced by reflections and acoustical standing waves in the propagating medium. For the electrical impedance measurements, a wafer piece or a thin slice of damping material (throughout this disclosure the damping material is made of Aptflex F28, 1.5 mm thick) is placed in front of the transducer at a distance of only a few mm.

Figure 2 shows measurements of the impedance and phase as function of the frequency. The left and right axes show the impedance and phase, respectively. The left column (fig. 2a) represents the measurements when a wafer piece is present and the right column shows the tests with a thin slice of damping material in front of the transducer (fig. 2b). In both cases, the distance to the transducer is varied, and some typical results are shown in Figure 2.

The duration of each measurement point is sufficiently long so that a standing wave between the wafer and transducer is developed. The real part of the impedance and the phase angle are measured in the frequency range of 0.9 to 1.1 MHz in steps of 0.5 kHz. The measurements clearly show an influence of reflected acoustic waves on the impedance and phase data.

The acoustic reflections can be decreased by using a damping material (right column in Figure 2) and, in this case, only one resonance peak for both phase and impedance can be detected, which is the fundamental resonance of the transducer.

The frequency-offset between the phase and impedance data is attributed to the parasitic capacitance of the transducer that is resulting from the small thickness of the piezoceramic and its high dielectric constant.

The FWHM (full width at half maximum) of the impedance peak in the graphs of figure 2b is quite large (around 40 kHz), which is caused by a thin slice of damping material that is unable to absorb all the acoustic waves. A variation of the distance between transducer and damping material has only a minor effect on the impedance peak, because its width and position vary only slightly.

If a wafer piece is present (left column Figure 2, i.e. a standard wafer and no damping material), the impedance peaks change drastically. At several wafer positions, more than one impedance or phase peak is present. The FWHM of the impedance peak is much smaller ($\sim$ 15 kHz) compared to the case when the damping material is used. The existence of several resonance peaks at certain wafer positions can make it difficult to use a feedback loop that corrects for a shift of the resonance frequency. Thus, the acoustic reflections have a large impact on the resonance frequencies of a transducer.

The resonance dependence of the transducer on the reflection of acoustic waves was further investigated by connecting the small cell to an amplifier/function generator setup. For each position of the damping material or wafer piece, the frequency that corresponds to a zero phase shift between the voltage and current signal is plotted.

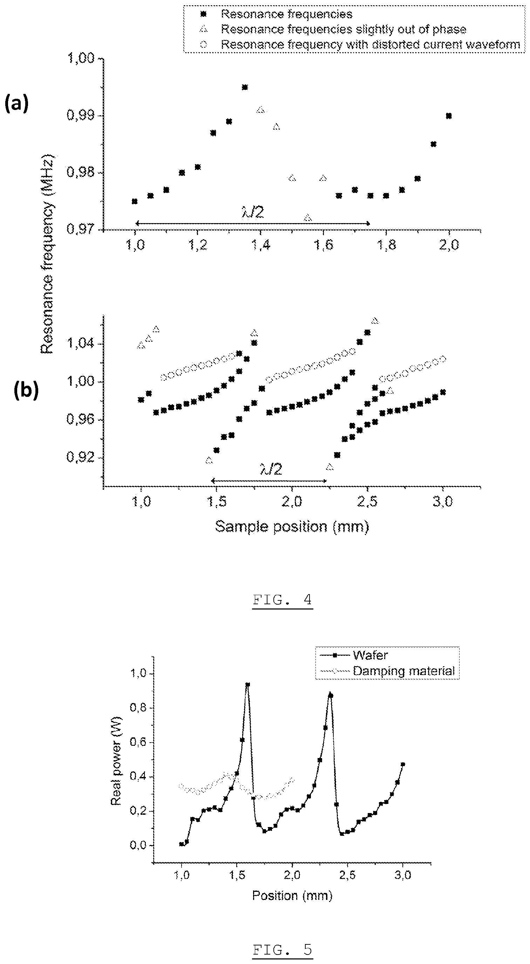

In Figure 4a (top), the resonance frequency is plotted as function of the distance between the damping material (minimizes acoustic reflection) and the transducer. There was always only one resonance frequency present; however, a zero phase shift could not be obtained completely for all damping material positions. The origin of this non-zero phase shift is the fact that a clamping capacitance is associated with a transducer element. During the measurements, the clamping capacitance was not corrected for, which means that the real resonance frequency lies not exactly at a zero phase shift.

In Figure 4b (bottom), the damping material is replaced by a wafer piece. The difference between the pictures in Figure 4a-4b (top and bottom) immediately shows the huge impact of acoustic reflections back into a transducer. At certain wafer positions, several resonance frequencies are present. It is even possible that the current waveform is clearly distorted (several frequencies present in the Fourier transform of the signal) for some resonance frequencies. Both pictures in Figure 4 show a clear periodicity, which corresponds to half of the wavelength of the acoustic waves.

Figure 5 represents the evolution of the real power as a function of the distance between the transducer and wafer/damping material. The real power equals the dissipated acoustical power in the liquid. The solid line with the squares points in Figure 5 shows the dependence of the real power as function of the variation of the distance between the wafer surface and the transducer. A very strong oscillation of the real power can be observed when reflections are present. If the wafer material is replaced with a thin slice of damping material, the oscillation is still present but it is clearly reduced (gray line with circular points in Figure 5). Since the slice of damping material is too thin to absorb all the acoustic waves, a small oscillation of the real power can still be observed.

Further, the influence of acoustic reflections on Particle Removal Efficiency (PRE) results has been investigated. The measurements were performed with the nozzle system described in figure 1a. The nozzle was driven with a function generator (peak-to-peak voltage of 2.05 V at a frequency of 1.02 MHz) and a high frequency amplifier (gain 100 x). The removal of particles is evaluated for 78 nm of $SiO_2$ particles deposited on a Si wafer and aged for 2 hours in a relative humidity of 40 %.

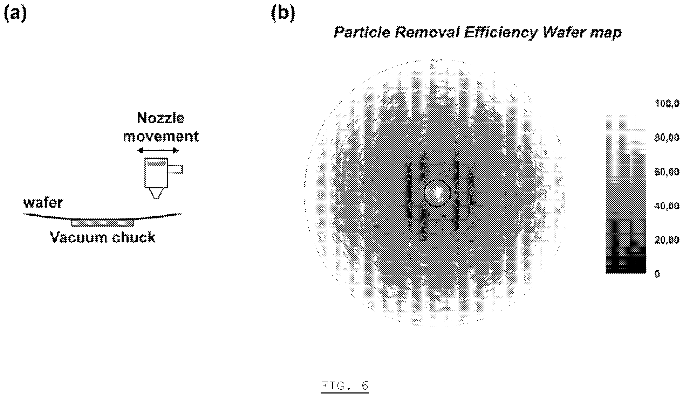

Cleaning performance is evaluated by measuring local PRE using light scattering in the haze mode. A typical measured PRE map shown in Figure 6 (b) indicates a non-uniform PRE. The radial non-uniformity is attributed to the existence of standing waves and is caused by a wafer which is slightly bent as shown schematically in Figure 6(a).

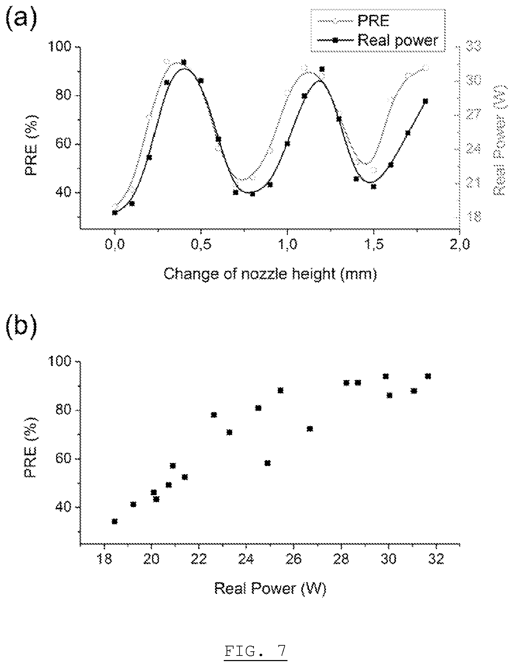

The wafer flexion changes the face-to-face distance between the transducer and wafer and immediately influences the dissipated acoustical power, as shown in Figure 5. To confirm this correlation, PRE maps are recorded in combination with electrical measurements. The nozzle was positioned above the centre of the wafer and the real power was measured at several wafer heights (distances between the wafer surface and the transducer) as shown in Figure 7a.

Next, a PRE wafer map was recorded for each nozzle height (corresponding to the distance between the wafer surface and the transducer fixed on said nozzle) and the average PRE in the centre of the wafer (circle with radius of 1 cm shown in Figure 6) was calculated. Figure 7a shows a strong oscillatory response of the real power and the PRE as a function of the transducer to wafer distance. The PRE and the real power follow the same trend (see fig. 7b). Both curves are correlated and oscillate with half of a wavelength of the acoustic waves. As a result, a direct correlation between reflected acoustic waves and particle removal efficiency data is established.

The reflections change the part of the electrical input impedance which is subject to electro-acoustical coupling described by eq. (1) and (2). This immediately influences the real electrical power delivered to the transducer, and thus the acoustical power delivered to the liquid. The observed oscillatory PRE response can thus be attributed to the oscillatory dependence of the power transmitted to the liquid.

The present disclosure reveals that reflected acoustic waves have a large impact on the performance of a transducer. In order to obtain an efficient cleaning, it is required to control the reflection of acoustic waves. By selecting and controlling the distance between wafer and transducer (resonance condition) according with the teaching of the present disclosure, the reflection of acoustic waves back into the transducer will enhance the real power consumed by the transducer. Further, enhancing the real power consumed by the transducer determines an increase of the dissipated acoustical power in the cleaning liquid and an improvement of the PRE.

The effective size of the transducer is defined as the area over which acoustic waves impinge on the surface and within which the major power (a substantial amount of the power) of the acoustic wave is confined.

In the embodiments wherein the surface to be cleaned is non-planar, the effective size of the transducer has to be chosen in relation to the non-planarity of the surface, such that at any position of the transducer facing the surface a clear distance value can be defined. This implies that the variation in distance between the transducer and the surface over the effective area of the transducer is small compared to the wavelength of the non-planar surface.

**Claims**

1. A method for cleaning a surface of a substrate (6,30), in particular a semiconductor substrate such as a silicon wafer, by the steps of :

    • Positioning the substrate (6,30) so that the surface is at a distance from a piezo-electric transducer (2,32),
    • Supplying a cleaning liquid (5) between the substrate and the transducer,
    • Applying an oscillating acoustic force to the cleaning liquid by actuating the transducer (2,32), i.e. by applying an alternating current and voltage to said transducer,
• Moving the transducer with respect to the substrate or vice versa,

**characterised in that** at several points in time during said movement the following sequence of steps is performed :

• Measuring the phase shift between the current and voltage applied to said transducer,
• Comparing the measured phase shift to a desired value of the phase shift,
• Adjusting the distance between the surface and the transducer so that said phase shift is maintained equal to said desired value of the phase shift.

2. Method according to claim 1, wherein said desired value of the phase shift is zero.

3. Method according to any one of claims 1 or 2, wherein said transducer (2, 32) is mounted in a nozzle (1,31) for producing a liquid column (5) between said nozzle and said surface.

4. Method according to claim 1 or 2, wherein said transducer is mounted against a side wall of a reservoir (10) configured to be filled with the cleaning liquid and to receive one or more substrates submerged in said liquid.

5. Apparatus for cleaning a surface of a substrate (6,30), comprising :

• a piezo-electric transducer (2,32),
• means (20,21) for positioning a substrate (6,30) at a controllable distance from said transducer,
• means (1,10) for providing a cleaning liquid (5) between the transducer and the substrate,
• means for connecting the transducer (2,32) to a power source, to thereby apply an alternating current and voltage to said transducer, **characterized in that** the apparatus further comprises
• means for measuring the phase shift between said current and voltage, and
• a feedback control system for adjusting said controllable distance so that said phase shift remains equal to a desired value.

6. Apparatus according to claim 5, wherein said means for providing a cleaning liquid comprises a nozzle (1,31) .

7. Apparatus according to claim 5, wherein said means for providing a cleaning liquid comprises a reservoir (10) in which a substrate may be submerged, and wherein the transducer (2) is attached to a side wall of said reservoir (10).

8. Apparatus according to any one of claims 5 to 7, wherein said feedback control system comprises an electromagnetically driven vertical positioning gear.

**Patentansprüche**

1. Verfahren zur Reinigung einer Oberfläche eines Substrats (6, 30), insbesondere eines Halbleitersubstrats, wie beispielsweise eines Siliciumwafers, durch die folgenden Schritte:

• Positionieren des Substrats (6, 30) derart, dass die Oberfläche in einem Abstand von einem piezoelektrischen Wandler (2, 32) ist,
• Zuführen einer Reinigungsflüssigkeit (5) zwischen dem Substrat und dem Wandler,
• Anwenden einer akustischen Schwingkraft auf die Reinigungsflüssigkeit durch Betätigen des Wandlers (2, 32), d. h. Anlegen eines Wechselstroms und einer Wechselspannung an den Wandler,
• Bewegen des Wandlers in Bezug auf das Substrat oder umgekehrt,

**dadurch gekennzeichnet, dass** zu mehreren Zeitpunkten während der Bewegung die folgende Abfolge von Schritten durchgeführt wird:

• Messen der Phasenverschiebung zwischen dem Strom und der Spannung, die an den Wandler angelegt werden,
• Vergleichen der gemessenen Phasenverschiebung mit einem gewünschten Wert der Phasenverschiebung,
• derartiges Anpassen des Abstands zwischen der Oberfläche und dem Wandler, dass die Phasenverschiebung gleich dem gewünschten Wert der Phasenverschiebung gehalten wird.

**2.** Verfahren nach Anspruch 1, wobei der gewünschte Wert der Phasenverschiebung null ist.

**3.** Verfahren nach einem der Ansprüche 1 oder 2, wobei der Wandler (2, 32) in einer Düse (1, 31) zum Herstellen einer Flüssigkeitssäule (5) zwischen der Düse und der Oberfläche montiert ist.

**4.** Verfahren nach Anspruch 1 oder 2, wobei der Wandler gegen eine Seitenwand eines Behälter (10) montiert ist, der ausgelegt ist, um mit der Reinigungsflüssigkeit gefüllt zu werden und ein oder mehrere Substrate aufzunehmen, die in die Flüssigkeit getaucht werden.

**5.** Vorrichtung zum Reinigen einer Oberfläche eines Substrats (6, 30), umfassend:

- einen piezoelektrischen Wandler (2, 32),
- Mittel (20, 21) zum Positionieren eines Substrats (6, 30) in einem regelbaren Abstand vom Wandler,
- Mittel (1, 10) zum Bereitstellen einer Reinigungsflüssigkeit (5) zwischen dem Wandler und dem Substrat,
- Mittel zum Verbinden des Wandlers (2, 32) mit einer Leistungsquelle, um dadurch einen Wechselstrom und eine Wechselspannung an den Wandler anzulegen, **dadurch gekennzeichnet, dass** die Vorrichtung ferner umfasst:
- Mittel zum Messen der Phasenverschiebung zwischen dem Strom und der Spannung und
- ein Regelungssystem mit Rückführung zum derartigen Anpassen des regelbaren Abstands, dass die Phasenverschiebung gleich einem gewünschten Wert bleibt.

**6.** Vorrichtung nach Anspruch 5, wobei das Mittel zum Bereitstellen einer Reinigungsflüssigkeit eine Düse (1, 31) umfasst.

**7.** Vorrichtung nach Anspruch 5, wobei das Mittel zum Bereitstellen einer Reinigungsflüssigkeit einen Behälter (10) umfasst, in den ein Substrat getaucht werden kann, und wobei der Wandler (2) an einer Seitenwand des Behälters (10) befestigt ist.

**8.** Vorrichtung nach einem der Ansprüche 5 bis 7, wobei das Regelungssystem mit Rückführung ein elektromagnetisch angetriebenes vertikales Positionierungszahnrad umfasst.

## Revendications

**1.** Procédé de nettoyage d'une surface d'un substrat (6, 30), en particulier d'un substrat semi-conducteur tel qu'une tranche de silicium, selon les étapes suivantes:

- placer le substrat (6, 30) de sorte que la surface soit à une distance d'un transducteur piézoélectrique (2, 32),
- prévoir un liquide de nettoyage (5) entre le substrat et le transducteur,
- appliquer une force acoustique oscillante au liquide de nettoyage en actionnant le transducteur (2, 32), c'est-à-dire en appliquant une tension et un courant alternatifs audit transducteur,
- déplacer le transducteur par rapport au substrat ou inversement,

**caractérisé en ce que**, à plusieurs moments pendant ledit mouvement, la séquence suivante d'étapes est exécutée :

- mesurer le changement de phase entre le courant et la tension appliqués audit transducteur,
- comparer le changement de phase mesuré avec une valeur souhaitée du changement de phase,
- Ajuster la distance entre la surface et le transducteur de sorte que ledit changement de phase soit maintenu égal à ladite valeur mesurée du changement de phase.

**2.** Procédé selon la revendication 1, dans lequel ladite valeur mesurée du changement de phase est de zéro.

**3.** Procédé selon l'une quelconque des revendications 1 ou 2, dans lequel ledit transducteur (2, 32) est monté dans une buse (1, 31) destinée à la production d'une colonne de liquide (5) entre ladite buse et ladite surface.

**4.** Procédé selon la revendication 1 ou 2, dans lequel ledit transducteur est monté contre une paroi latérale d'un réservoir (10) configuré pour être rempli avec le liquide de nettoyage et pour recevoir un ou plusieurs substrats immergés dans ledit liquide.

**5.** Appareil de nettoyage d'une surface d'un substrat (6, 30), qui comprend :

> • un transducteur piézoélectrique (2, 32),
> • un moyen (20, 21) destiné à positionner un substrat (6, 30) à une distance réglable par rapport audit transducteur,
> • un moyen (1, 10) destiné à prévoir un liquide de nettoyage (5) entre le transducteur et le substrat,
> • un moyen destiné à relier le transducteur (2, 32) à une source d'alimentation, de façon à appliquer une tension et un courant alternatifs audit transducteur, **caractérisé en ce que** l'appareil comprend en outre :
> • un moyen destiné à mesurer le changement de phase entre ledit courant et la tension, et
> • un système de commande à rétroaction destiné à ajuster ladite distance réglable de sorte que ledit changement de phase reste égal à une valeur désirée.

**6.** Appareil selon la revendication 5, dans lequel ledit moyen destiné à fournir un liquide de nettoyage comprend une buse (1, 31).

**7.** Appareil selon la revendication 5, dans lequel ledit moyen destiné à fournir un liquide de nettoyage comprend un réservoir (10) dans lequel un substrat peut être immergé, et dans lequel le transducteur (2) est fixé sur une paroi latérale dudit réservoir (10).

**8.** Appareil selon l'une quelconque des revendications 5 à 7, dans lequel le système de commande à rétroaction comprend un engrenage de positionnement vertical entraîné électromagnétiquement.

(a)

(b)

~ 4 mm

FIG. 1

Fig. 2a

Fig. 2b

FIG. 3

FIG. 4

FIG. 5

**(a)**

**(b)**

*Particle Removal Efficiency Wafer map*

FIG. 6

FIG. 7

**EP 2 270 838 B1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- WO 2004071938 A

- WO 138725 A

### Non-patent literature cited in the description

- **LIN et al.** The laser displacement measurement with feedback control in a magnetic levitation and suspension system. *Comput. Methods Appl. Mech. Engrg.,* 2000, vol. 190, 25-34

- **YI et al.** Robust force control for a magnetically levitated manipulator using flux density measurement. *Control Eng. Practice,* 1996, vol. 4 (7), 957-965